(19) Europäisches Patentamt
European Patent Office
Office européen des brevets

(11) **EP 2 765 432 A2**

(12) **EUROPÄISCHE PATENTANMELDUNG**

(43) Veröffentlichungstag:
**13.08.2014  Patentblatt 2014/33**

(51) Int Cl.:
***G01R 31/315*** *(2006.01)*  ***G01R 31/06*** *(2006.01)*
***G01R 29/10*** *(2006.01)*

(21) Anmeldenummer: **14000421.9**

(22) Anmeldetag: **05.02.2014**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **07.02.2013  DE 102013002138**

(71) Anmelder: **Giesecke & Devrient GmbH
81677 München (DE)**

(72) Erfinder:
• **Finkenzeller, Klaus
85774 Unterföhring (DE)**
• **Baldischweiler, Michael
81825 München (DE)**

(54) **Verfahren und Vorrichtung zum Prüfen eines Schaltkreises eines Endgeräts**

(57)    Ein Verfahren zum Prüfen eines Schaltkreises (20) mit induktiv koppelnder Antenne für ein Endgerät umfasst folgende Schritte: Der Schaltkreis (20)wird mittels eines Energiepulses zur Schwingung angeregt (S3; A1). In einem weiteren Schritt wird die Schwingung des Schaltkreises in Antwort auf die Anregung des Schaltkreises durch den Energiepuls erfasst (S4; A2). Die erfasste Schwingung des Schaltkreises wird schließlich ausgewertet (S5; A3), insbesondere hinsichtlich einer Eigenresonanzfrequenz des Schaltkreises (20). Bevorzugt kann der Schritt des Auswertens der erfassten Schwingung in Abhängigkeit einer Feldstärke (H) erfolgen, in der sich der Schaltkreis (20) befindet. Dazu können die Schritte des Erzeugen (S1) eines magnetischen Wechselfeldes vorgegebener Feldstärke (H) und des Anordnens (S2) des Schaltkreises (20) in dem Wechselfeld dem Schritt des Anregens (S3; A1) des Schaltkreises (20) vorgeschaltet werden.

Das Erfassen (S4; A2) der Schwingung des Schaltkreises (20) kann mittels einer Breitband-Messantenne (140) erfolgen.

FIG 1

EP 2 765 432 A2

**Beschreibung**

Die vorliegende Erfindung betrifft ein Verfahren und eine Messvorrichtung zum Prüfen eines zur kontaktlosen Datenkommunikation eingerichteten Schaltkreises eines Endgeräts, wobei der Schaltkreis eine Antenne, insbesondere eine induktiv koppelnde Antenne eines RFID- oder NFC-Moduls des Endgeräts, und ein mit der Antenne gekoppeltes elektronisches Bauteil, also insbesondere der RFID- oder NFC-Chip, umfasst. Die Erfindung umfasst weiterhin eine Breitband-Messantenne, welche eingerichtet sein kann, als Messantenne der Messvorrichtung zu dienen.

Das Prüfen des Schaltkreises kann dabei sowohl elektronische Eigenschaften des Schaltkreises als auch die Funktionsfähigkeit des Schaltkreises oder einzelner Komponenten des Schaltkreises betreffen.

Der Schaltkreis ist eingerichtet, in ein Endgerät integriert zu werden, wie beispielsweise ein Mobilfunkendgerät, ein Smartphone oder ein entsprechendes Lesegerät zur kontaktlosen Kommunikation mit einem kontaktlos kommunizierenden Gerät oder Datenträger. Der Schaltkreis kann insbesondere als RFID- oder NFC-Modul ausgebildet sein, welches vorgesehen ist, fest in ein Endgerät der genannten Art integriert zu werden.

Um die Funktionsfähigkeit einer Antennenspule während oder nach der Herstellung des Schaltkreises zu prüfen, sind verschiedene Verfahren bekannt. Bei einer solchen Prüfung wird im Wesentlichen geprüft, ob die Antennenspule einen Bruch aufweist und/ oder ob zwei oder mehr Spulenwindungen der Antenne versehentlich kurzgeschlossen sind. Mängel dieser Art beeinträchtigen die Funktionsfähigkeit der Antennenspule erheblich bzw. zerstören diese vollständig. Eine Prüfung des Schaltkreises, bestehend aus der Antenne und dem mit der Antenne verbundenen elektronischen Bauteil, kann, wie bereits erwähnt, auch die Funktionsfähigkeit des Bauteils oder einzelner Komponenten des Bauteils betreffen.

Produktionsbegleitend erfolgt bisher zumeist eine Prüfung der Antennenspule in Form einer Gleichstrom-Widerstandsmessung. Ein solches Prüfverfahren ist aufwendig, da eine Kontaktierung der Antennenspule erforderlich ist. Weiterhin können nur bestimmte Fehler des geprüften Schaltkreises erkannt werden. Eine Fehlfunktion eines oder mehrerer Komponenten des elektronischen Bauteils oder ein Leiterbahnbruch in bestimmten Bereichen der Antenne sind auf diese Weise nicht oder kaum erkennbar.

Alternativ können die Resonanzfrequenz der Antennenspule und deren Güte kontaktlos bestimmt werden. Dazu wird in der Regel ein Phasen- und Impedanz-Analysator verwendet. Ein solches, sehr aufwendiges Verfahren ist detailliert beispielsweise im "RFID-Handbuch" von Klaus Finkenzeller, 6. Auflage, Carl Hanser Verlag, München, 2012, in Kapitel 4.1.11.2, beschrieben. Liegt die gemessene Resonanzfrequenz in einem vorgegebenen Bereich, so ist die Antennenspule funktionsfähig. Diese Art der Prüfung ist aussagekräftiger als eine rein ohmsche Messung, allerdings ungleich aufwendiger und am besten manuell durchzuführen. Die Zeitdauer einer solchen Prüfung liegt im Bereich von mehreren Sekunden. Daher wird diese Prüfung in der Regel nicht produktionsbegleitend durchgeführt, sondern lediglich an einigen Stichproben und für die Produktionsfreigabe.

Weiterhin können Eigenschaften des Analysators, beispielsweise die Impedanz einer Messantenne, das Ergebnis der Messung beeinflussen. Verschiedene Analysatoren und Messaufbauten führen daher in der Regel zu abweichenden Messergebnissen.

Aufgabe der vorliegenden Erfindung ist es demnach, ein Verfahren und eine Messvorrichtung zur schnellen, einfach durchzuführenden und kostengünstigen Prüfung eines Schaltkreises mit induktiv koppelnder Antenne in einem Endgerät, insbesondere hinsichtlich dessen Eigenresonanzfrequenz, vorzuschlagen. Bevorzugt soll das Verfahren eine präzise und reproduzierbare Messung insbesondere der Eigenresonanzfrequenz des Schaltkreises erlauben.

Diese Aufgabe wird durch ein Verfahren und eine Messvorrichtung mit den Merkmalen der unabhängigen Ansprüche gelöst. Vorteilhafte Ausgestaltungen und Weiterbildungen der Erfindung sind in den abhängigen Ansprüchen angegeben.

Ein Grundgedanke der vorliegenden Erfindung besteht darin, den zu prüfenden Schaltkreis mittels eines Energiepulses zur Schwingung anzuregen und die durch die Anregung erzeugte Schwingung des Schaltkreises, welche einer freien, gedämpften Schwingung entspricht, zu erfassen und auszuwerten. Aus der erfassten Schwingung können dann, wie nachfolgend im Detail beschrieben, Eigenschaften des Schaltkreises abgelesenen werden, wie beispielsweise die Eigenresonanzfrequenz oder die Güte des Schaltkreises.

Ein erfindungsgemäßes Verfahren zum Prüfen eines zur kontaktlosen Datenkommunikation eingerichteten Schaltkreises eines Endgeräts, wobei der Schaltkreis eine induktiv koppelnde Antenne, insbesondere eine RFID- oder NFC-Antennenspule eines RFID- oder NFC-Moduls des Endgeräts, und ein mit der Antenne gekoppeltes elektronisches Bauteil umfasst. Die Antenne ist vorzugsweise eine Antennenspule mit mindestens einer Leiterschleife. Das Verfahren umfasst die folgenden Schritte:

Der elektronische Schaltkreis wird in einem ersten Schritt mittels eines Energiepulses zur Schwingung angeregt. In der Regel erfolgt das Anregen des Schaltkreises als induktives Anregen mittels eines gepulsten Magnetfeldes. Das Magnetfeld wird dabei vorzugsweise durch einen einzelnen Strompuls erzeugt. Der Strompuls kann dabei vorzugsweise als Gleichstrompuls in Form eines Dirac-Stoßes erzeugt werden. Alternativ kann auch ein Strompuls erzeugt werden, der lediglich eine steile Flanke aufweist. Vorzugsweise erfolgt das Anregen des Schaltkreises kontaktlos mittels einer externen Erregerspule.

In einem weiteren Schritt wird die Schwingung des Schaltkreises in Antwort auf die Anregung des Schaltkreises durch den Energiepuls erfasst. Das Erfassen der Schwingung des Schaltkreises erfolgt ebenfalls vorzugsweise kontaktlos mittels einer externen Messantenne. Erregerspule und Messantenne werden dabei vorzugsweise in unmittelbarer Nähe des zu prüfenden Schaltkreises angeordnet.

Die erfasste Schwingung des Schaltkreises wird schließlich ausgewertet, insbesondere hinsichtlich einer Eigenresonanzfrequenz und / oder Güte des Schaltkreises. Dies kann mittels einer Auswertungseinrichtung erfolgen, die mit der Messantenne verbunden ist.

Eine erfindungsgemäße Messvorrichtung zum Prüfen eines zur kontaktlosen Datenkommunikation eingerichteten Schaltkreises umfasst dabei folgende Komponenten:

Ein Impulsgeber ist eingerichtet, einen in der Messvorrichtung anordenbaren, zu prüfenden Schaltkreis über eine an den Impulsgeber angeschlossene Erregerspule kontaktlos anzuregen.

Eine Messantenne ist eingerichtet, eine Schwingung eines angeordneten, zu prüfenden Schaltkreises zu erfassen.

Eine Auswertungseinrichtung schließlich, welche mit der Messantenne verbunden ist, ist eingerichtet, die von der Messantenne erfasste Schwingung des zu prüfenden Schaltkreises auszuwerten, insbesondere hinsichtlich einer Eigenresonanzfrequenz des Schaltkreises.

Die Auswertungseinrichtung kann dabei insbesondere einen Vergleich mit Referenzwerten einer intakten Antennenspule heranziehen. Zur Analyse der von der Messantenne beim Erfassen der Schwingung, d.h. der freien, gedämpften Schwingung, erfassten Signale kann in bekannter Weise beispielsweise ein digitaler Signalprozessor (DSP) oder ein Oszilloskop dienen.

Ein durch einen Energiepuls angeregter Schaltkreis schwingt nach der Anregung grundsätzlich unmittelbar mit einer freien, gedämpften Schwingung A(t) aus, welche mit der folgenden Formel beschrieben werden kann:

$$A(t) = A_0(t)\, e^{(-\delta t)} \cos \omega t.$$

A(t) kann dabei dem Strom I oder der Spannung U eines durch den Schaltkreis gebildeten elektrischen Schwingkreises entsprechen. Demnach kann der Spannungsverlauf des Schaltkreises unmittelbar nach der Anregung mit der folgenden Formel beschrieben werden:

$$U(t) = U_0(t)\, e^{(-\delta t)} \cos \omega t$$

Die Kreisfrequenz $\omega$ entspricht dabei der Eigenresonanzfrequenz des Schaltkreises fres multipliziert mit 2 n ($\omega$ =2 n fres). Aus dem Abklingkoeffizienten $\delta$ und der Eigenresonanzfrequenz $f_{res}$ kann die Güte Q des Schaltkreises ermittelt werden. Alternativ kann die Güte Q auch aus zwei aufeinander folgenden Maxima An und $A_{n+1}$ der Schwingungsamplitude des Schaltkreises ermittelt werden.

$$Q = \frac{\pi * f_{res}}{\delta} = \frac{\pi}{\ln(\frac{A_n}{A_{n+1}})}$$

Je länger der Abklingvorgang dauert, desto höher ist die Güte des entsprechenden Schwingkreises. D.h. eine Auswertung der freien, gedämpften Schwingung des Schaltkreises, d. h. deren Ausschwingen unmittelbar nach der Anregung, erlaubt es, sowohl die Eigenresonanzfrequenz als auch die Güte des Schaltkreises zu bestimmen.

Ein Aspekt der Erfindung beruht nun auf dem Umstand, dass ein Defekt der Antenne des zu prüfenden Schaltkreises, wie beispielsweise eine Unterbrechung einer Leiterbahn oder ein Kurzschluss zwischen einzelnen Spulenwindungen einer als Antennenspule ausgebildeten Antenne, dazu führt, dass sich ein bei einer beschriebenen Prüfung erkennbarer Signalverlauf des Ausschwingens signifikant von einem entsprechenden Signalverlauf des Ausschwingens einer intakten Antennenspule unterscheidet. Anhand der ausgewerteten freien, gedämpften Schwingung festgestellte Parameter einer fehlerhaften Antenne, insbesondere deren Eigenresonanzfrequenz und deren Güte, unterscheiden sich deutlich von den entsprechenden Parametern einer intakten Antenne.

Ein Leiterbahnbruch beispielsweise zeigt sich in einem deutlich erkennbar veränderten Ausschwingverhalten, insbesondere einer veränderten, in der Regel erhöhten Eigenresonanzfrequenz. Im Falle eines Kurzschlusses von zwei oder mehr Spulenwindungen ist kaum mehr ein Ausschwingen zu beobachten.

Auf diese Weise kann beim Auswerten der freien, gedämpften Schwingung durch die Prüfvorrichtung nicht nur erkannt werden, ob die Antennenspule fehlerhaft ist oder nicht, sondern es kann im Falle eines Fehlers oder Mangels auch der Typ des Fehlers bzw. die Art des Mangels festgestellt werden.

Die Vorteile des erfindungsgemäßen Verfahrens sind offensichtlich und zahlreich. Die Prüfung des Schaltkreises, insbesondere der Antenne des Schaltkreises, kann kontaktlos und mit sehr geringem Zeitaufwand erfolgen. Dies erlaubt für geeignete Ausführungsformen von Schaltkreisen eine Prüfung während eines laufenden Produktionsprozesses. Insbesondere kann auch bereits eine gedruckte Antennenspule, welche noch nicht vollständig ausgehärtet ist, mit dem erfindungsgemäßen Verfahren geprüft werden. Die benötigte Messvorrichtung ist vergleichsweise einfach und kostengünstig bereitzustellen. Zudem erlaubt das Verfahren nicht nur, Fehler oder Mängel einer defekten Antenne des Schaltkreises zu erkennen, sondern auch verschiedene Fehlertypen eines zu prüfenden Schaltkreises zu unterscheiden.

Ein weiterer Aspekt der Erfindung betrifft eine Breitband-Messantenne. Diese kann eingerichtet sein, als Messantenne der vorstehend beschriebenen, erfindungsgemäßen Messvorrichtung zu dienen.

Grundsätzlich sollte eine Messantenne der betreffenden Art, d.h. eine Messantenne, die eingerichtet ist, eine Schwingung, beispielsweise eines gemäß dem erfindungsgemäßen Verfahren angeregten Schaltkreises, zu erfassen, bestimmte technischen Eigenschaften zeigen. Eine solche Messantenne sollte derart ausgebildet sein, dass sie selbst durch ihre physikalischen Eigenschaften eine Messung, beispielsweise einer Schwingung eines Schaltkreises, nicht oder nur unwesentlich beeinflusst. Dazu sollte die Messantenne möglichst breitbandig ausgelegt sein und lediglich eine sehr gering ausgeprägte Spannungsüberhöhung im Bereich ihrer Resonanzfrequenz aufweisen. Insbesondere sollte ein Ausschwingen der Messantenne, beispielsweise in Reaktion auf eine Anregung, im Wesentlichen unterdrückt werden.

Um dies zu erreichen, umfasst eine erfindungsgemäße Breitband-Messantenne eine Leiterschleife und eine Mehrzahl ohmscher Widerstände. Die Widerstände sind in vorgegebenen Abständen entlang der Leiterschleife in die Leiterschleife eingefügt. Mit anderen Worten, durch das Einfügen der Widerstände in die Leiterschleife entsteht eine Mehrzahl von Leitungssegmenten der Leiterschleife. Entlang der Leiterschleife benachbarte Leitungssegmente sind dabei durch je einen der ohmschen Widerstände verbunden. Dadurch sind Leitungssegmente und Widerstände jeweils abwechselnd und in Reihe geschaltet.

Auf diese Weise entsteht eine Leiterschleife mit dazu in Reihe geschaltetem hochohmigem Widerstand. Dies könnte zwar grundsätzlich auch dadurch erreicht werden, dass ein einzelner hochohmiger Widerstand in Reihe mit der Leiterschleife geschaltet wird. Da in der Praxis aber auch parasitäre Kapazitäten in Betracht gezogen werden müssen, die sich entlang der Leiterschleifen bilden, hat der beschriebene Aufbau der erfindungsgemäßen Breitband-Messantenne verschiedene Vorteile.

Dadurch, dass der Widerstand nicht als einzelner Widerstand vorliegt, sondern als Mehrzahl entlang der Leiterschleife geschalteter "Teilwiderstände", werden die auftretenden parasitären Kapazitäten nicht mehr als Gesamtkapazität wirksam. Mit anderen Worten, während ein einzelner Widerstand, der in Reihe zu der Leiterschleife geschaltet werden würde, aufgrund einer entlang der Leiterschleife auftretenden parasitären Kapazität, welche dann als Gesamtkapazität in Erscheinung treten würde, zusammen mit der Induktivität der Leiterschleife einen Schwingkreis mit ungünstigerweise hoher Güte - wegen des hochohmigen Scheinwiderstandes - bilden würde, erlaubt der erfindungsgemäße Aufbau eine wirksame Dämpfung der Breitband-Messantenne.

Gegenüber einer Ausführungsform, bei der der Widerstand dadurch entlang der Leiterschleife "gleichmäßig" verteilt wird, dass die Leiterschleife einer Messantenne aus einem hochohmigen Material, wie beispielsweise Graphit, hergestellt wird, hat der beschriebene, erfindungsgemäße Aufbau den Vorteil einer einfachen und insbesondere kostengünstigeren Herstellung.

Ein weiterer Vorteil der erfindungsgemäßen Breitband-Messantenne besteht darin, dass, bedingt durch den hohen Widerstand der Leiterschleife, ein während einer Messung, beispielsweise im Rahmen des erfindungsgemäßen Verfahrens, in der Antenne fließender Strom gegen Null geht. Mit anderen Worten, an den Anschlüssen der Breitband-Messantenne wird praktisch nur Spannung gemessen. Wird aber der Strom in der Breitband-Messantenne sehr klein, so wird dadurch auch eine Rückwirkung auf einen Messgegenstand, beispielsweise eine Antenne eines zu prüfenden Schaltkreises, minimiert. Dadurch wird das Messergebnis durch die Breitband-Messantenne praktisch nicht beeinflusst.

Die Abstände zwischen je zwei entlang der Leiterschleife benachbart eingefügten Widerständen sind dabei vorzugsweise regelmäßig. Die Anzahl, der Abstand und die Dimension der Widerstände sind grundsätzlich variabel.

Vorzugsweise werden zumindest fünf Widerstände entlang der Leiterschleife angeordnet, vorzugsweise 8 bis 10 Widerstände, die Anzahl kann aber auch größer sein. In der Regel sind die Widerstände gleich dimensioniert, Abweichungen zwischen einzelnen Widerstandswerten sind möglich.

Im Rahmen des erfindungsgemäßen Prüfverfahrens und mit Bezug auf eine erfindungsgemäße Messvorrichtung werden die Erregerspule und die Messantenne der Messvorrichtung, beispielsweise die erfindungsgemäße Breitbandantenne, vorzugsweise orthogonal zueinander angeordnet. In dem Fall, dass die Erregerspule und die Messantenne nicht orthogonal zueinander, sondern beispielsweise nebeneinander angeordnet sind, wird der Erregungspuls der Erregerspule auch von der Messantenne erfasst. Zudem überlagert dann das Abschwingverhalten der Erregerspule das zu messende Abschwingverhalten der Antennenspule.

Bei einer "orthogonalen" Anordnung der Erregerspule zu der Messantenne liegen diese derart zueinander, dass das Signal der Erregerspule von der Messantenne nicht wahrgenommen wird. Die Erregerspule ist dabei gegenüber der Messantenne räumlich so angeordnet, dass in der Messantenne im Wesentlichen kein Signal eingekoppelt wird. Ein Signal wird in eine Spule immer dann eingekoppelt, wenn das Ringintegral über den magnetischen Fluss $\Phi$ durch diese Spule größer als Null ist (vgl. oben zitiertes RFID-Handbuch, Kapitel 4.1.6 und 4.1.9.2). Das Integral über den magnetischen Fluss $\Phi$ ist genau dann Null, wenn sich magnetische Feldlinien unterschiedlicher Richtung und Feldstärke in der Messantenne über die Gesamtfläche gegenseitig aufheben, oder wenn der Winkel der Feldlinien zur Spulenachse genau 90° beträgt - daher der Begriff "orthogonale" Anordnung. Eine geeignete, so genannte koplanare orthogonale Anordnung der Erregerspule zur Messantenne kann beispielsweise derart erfolgen, dass die beiden Antennen in einer Ebene geeignet teilweise übereinander liegen.

Vorzugsweise ist an die Messantenne der Messvorrichtung unmittelbar ein Verstärker angeordnet. Dadurch kann eine lange, kapazitätsbelegte Zuleitung vermieden werden. Der Verstärker umfasst bevorzugt einen hochohmigen Eingang. Als Verstärker kann beispielsweise ein Impedanzwandler verwendet werden. Dessen Ausgangsimpedanz ist dann vorzugsweise an ein Übertragungsmittel angepasst, welches den Impedanzwandler mit der Auswertungseinrichtung verbindet. Als Verbindungsmittel wird vorzugsweise ein Koaxialkabel verwendet. In diesem Fall beträgt die Ausgangsimpedanz des Impedanzwandlers 50 $\Omega$.

Die Auswertungseinrichtung, welche beispielsweise ein Oszilloskop sein kann, weist bevorzugt eine Eingangsimpedanz auf, welche in gleicher Weise an ein Übertragungsmittel angepasst ist, welches die Auswertungseinrichtung mit der Messantenne verbindet, beispielsweise das genannte Koaxialkabel.

Ein Aspekt einer bevorzugten Ausführungsform der vorliegenden Erfindung basiert weiterhin auf der Erkenntnis, dass elektrische Eigenschaften eines zu prüfenden Schaltkreises, insbesondere die Eigenresonanzfrequenz und die Güte des Schaltkreises, abhängig sind von der Feldstärke eines magnetischen Wechselfeldes, in dem sich der Schaltkreis während oder kurz vor der Messung, d.h. der Anregung durch den Energiepuls, befindet. Da bekannte Verfahren diese Einflussgröße bisher unbeachtet gelassen haben, waren genaue und reproduzierbare Messungen entsprechender Eigenschaften nicht möglich.

Ein Grund für die Feldstärkeabhängigkeit der Resonanzfrequenz und der Güte eines entsprechenden Schaltkreises liegt in den physikalischen Eigenschaften elektronischer Komponenten des Schaltkreises. Zur Gewinnung einer Versorgungsspannung eines Chips des Schaltkreises kann die Antenne des Schaltkreises mit einem Gleichrichterbauteil verbunden sein. Die von der Antenne gesehene Impedanz des Gleichrichters hängt dabei von dem Strom ab, welcher in den Gleichrichter fließt. Weitere Einflussgrößen sind spannungsabhängige Sperrschichtkapazitäten des Gleichrichterbauteils sowie gegebenenfalls Transistorbauteile auf dem Chip, der dynamische Gleich- und Wechselstromwiderstand des Gleichrichterbauteils sowie eine daraus resultierende Eingangskapazität des Chips. Mit anderen Worten, die Resonanzfrequenz des Schaltkreises hängt indirekt aus den genannten Gründen von einem magnetischen Wechselfeld ab, in dem sich der Schaltkreis während der Messung befindet.

Um diesem Umstand Rechnung zu tragen, zeichnet sich eine bevorzugte Ausführungsform des erfindungsgemäßen Verfahrens dadurch aus, dass das Auswerten der erfassten Schwingung in Abhängigkeit von der Feldstärke eines magnetischen Wechselfeldes erfolgt, in welchem der Schaltkreis angeordnet ist.

Das Auswerten der erfassten Schwingung kann insbesondere in Abhängigkeit eines durch das Vorliegen des magnetischen Wechselfeldes bedingten Betriebs- oder Schaltungszustandes einer oder mehrerer Komponenten des elektronischen Bauteils des Schaltkreises erfolgen. Die angesprochenen Betriebs- oder Schaltungszustände können beispielsweise die Ladung eines Kondensators betreffen oder den Stromfluss durch ein Gleichrichter-Bauteil.

Eine konkrete Ausgestaltung der bevorzugten Ausführungsform des erfindungsgemäßen Verfahrens umfasst demnach die weiteren Schritte des Erzeugens eines magnetischen Wechselfeldes vorgegebener Feldstärke und des Anordnens des Schaltkreises in dem Wechselfeld. Die beiden Schritte werden dabei vor dem Schritt des Anregens des Schaltkreises mittels des Energiepulses durchgeführt.

Das magnetische Wechselfeld kann dabei mittels einer Sendeantenne erzeugt werden. Weiterhin kann vorgesehen sein, die Feldstärke des Wechselfeldes in einem vorgegebenen Bereich mittels einer Kalibrierantenne zu messen, um ein Erzeugen des Wechselfeldes gemäß der vorgegebenen Feldstärke in präziser und nachprüfbarer Weise zu ermöglichen.

Die Kalibrierantenne und die Antenne des zu prüfenden Schaltkreises werden dabei vorzugsweise derart relativ zur Sendeantenne angeordnet, dass im Bereich der Kalibrierantenne und im Bereich der Antenne des Schaltkreises jeweils ein magnetisches Wechselfeld der gleichen Feldstärke vorliegt. Auf diese Weise wird es ermöglicht, dass die Prüfung des Schaltkreises in einer genau vorgebbaren, standardisierten Umgebung, d.h. bei einem in vorgegebener Feldstärke vorliegenden magnetischen Wechselfeld, durchgeführt werden kann. Dies erlaubt erstmals eine sehr präzise und reproduzierbare Messung der entsprechenden physikalischen Eigenschaften des Schaltkreises, insbesondere der Resonanzfrequenz und der Güte des Schaltkreises.

Das magnetische Wechselfeld wird dabei derart erzeugt, dass der darin angeordnete Schaltkreis in eine bezüglich Amplitude und Frequenz konstante sinusförmige Schwingung versetzt wird. Die Frequenz entspricht dabei vorzugsweise einer Betriebsfrequenz des Schaltkreises, beispielsweise eine Frequenz von 13,56 MHz.

Gemäß einer ersten Variante der bevorzugten Ausführungsform des erfindungsgemäßen Verfahrens wird der Schaltkreis, wie beschrieben, im Bereich des magnetischen Wechselfeldes angeordnet und das Wechselfeld liegt zum Zeitpunkt des Anregens des Schaltkreises mittels des Energiepulses in konstanter Weise vor. Mit anderen Worten, das Anregen des Schaltkreises durch den Energiepuls erfolgt bei dauerhaft angeschaltetem magnetischem Wechselfeld. Beim Auswerten der erfassten Schwingung wird dann derjenige Anteil der erfassten Schwingung berücksichtigt, welcher durch das Wechselfeld hervorgerufen wird. Dabei handelt es sich um die vorstehend erwähnte, konstante sinusförmige Schwingung.

Im Rahmen dieser ersten Variante umfasst das Erfassen der Schwingung des Schaltkreises ein Erfassen einer Überlagerung einer durch das Wechselfeld hervorgerufenen sinusförmigen Schwingung des Schaltkreises mit einer freien, gedämpften Schwingung des Schaltkreises, welche aus der Anregung des Schaltkreises durch den Energiepuls resultiert.

Das Auswerten der erfassten Schwingung des Schaltkreises kann mittels einer Subtraktion der konstanten sinusförmigen Schwingung von der erfassten Schwingung erfolgen. Auf diese Weise kann die freie, gedämpfte Schwingung des Schaltkreises ermittelt werden.

Um eine solche Vorgehensweise zu unterstützen, kann die sinusförmige Schwingung vor dem Anregen durch den Energiepuls, oder in hinreichendem Abstand nach dem Anregen, d.h. wenn die freie, gedämpfte Schwingung bereits ausgeklungen ist, erfasst und hinsichtlich Amplitude, Phase und Frequenz ermittelt und in einer Auswertungseinrichtung gespeichert werden.

Die Subtraktion der konstanten sinusförmigen Schwingung von der erfassten Schwingung des Schaltkreises kann mittels Software oder mittels Hardware erfolgen. In der Hardwarevariante kann ein Verstärker verwendet werden. Die beschriebene Subtraktion kann dann vorzugsweise durch Addition eines Signals erfolgen, welches dem von der Kalibrierantenne erfassten und dann invertierten Signal entspricht, d.h. durch Addition der invertierten Sinusschwingung.

Ein Aspekt des Verfahrens gemäß der vorstehend beschriebenen, bevorzugten Ausführungsform betrifft eine präzise Messung der Eigenresonanzfrequenz des Schaltkreises unter vorgegebenen äußeren Bedingungen, d.h. in einem magnetischen Wechselfeld konstanter, vorgegebener Feldstärke. Dies erlaubt eine entsprechende Messung in reproduzierbarer Weise und insbesondere bei einer Betriebsfeldstärke des Schaltkreises.

Ein weiterer Aspekt dieser Ausführungsform betrifft schließlich die Tatsache, dass bei Vorliegen eines intakten Schaltkreises bei verschiedenen Feldstärken jeweils, wenn auch gegebenenfalls nur geringfügig, voneinander abweichende Resonanzfrequenzen ermittelt werden sollten. Mit anderen Worten, werden bei wiederholtem Durchführen des beschriebenen Verfahrens gemäß der bevorzugten Ausführungsform - bei jeweils verschiedenen Feldstärken des magnetischen Wechselfeldes - gleiche Resonanzfrequenzen ermittelt, so spricht dies für einen Defekt des elektronischen Bauteils bzw. solcher Elemente des Bauteils, welche grundsätzlich mit für eine Abhängigkeit der Resonanzfrequenz von der Feldstärke verantwortlich sind.

Das Verfahren gemäß der bevorzugten Ausführungsform liefert daher folgende zusätzliche Vorteile. Erstmals kann die Resonanzfrequenz eine RFID- oder NFC-Moduls eines Endgeräts präzise und reproduzierbar, unter variabel, aber fest einstellbaren Bedingungen, ermittelt werden. Ein bisher nicht erfassbarer Einfluss eines magnetischen Wechselfeldes auf Messergebisse kann nun in präziser Weise vorgegeben und in der Messung berücksichtigt werden. Dies ermöglicht eine präzise Messung physikalischer Eigenschaften des betreffenden Schaltkreises unter eindeutig reproduzierbaren Messbedingungen.

Gemäß einer zweiten Variante der bevorzugten Ausführungsform des erfindungsgemäßen Verfahrens kann der Schaltkreis im Bereich des magnetischen Wechselfeldes angeordnet werden und das Wechselfeld zum Zeitpunkt des Anregens des Schaltkreises mittels des Energiepulses abgeschaltet sein. Dabei erfolgt die Abschaltung des Wechselfeldes zeitlich erst derart kurz vor dem Anregen des Schaltkreises durch den Energiepuls, dass Einflüsse des zuvor vorliegenden, noch angeschalteten Wechselfeldes auf Betriebs- und Schaltungszustände einer oder mehrerer Komponenten des elektronischen Bauteils weiterhin vorliegen. D.h. der Schaltkreis ist zum Zeitpunkt des Anregens noch mit Energie versorgt. Mit anderen Worten, das magnetische Wechselfeld wird zumindest kurzzeitig abgeschaltet und das Anregen des Schaltkreises durch den Energiepuls erfolgt bei abgeschaltetem magnetischen Wechselfeld. Diese zweite Variante hat den Vorteil, dass das Auswerten der erfassten Schwingung dadurch einfacher wird, dass kein der sinus-

**EP 2 765 432 A2**

förmigen Schwingung entsprechender Schwingungsanteil von dem erfassten Signal subtrahiert werden muss.

Wir erwähnt, wird das magnetische Wechselfeld vorzugsweise nur kurzfristig abgeschaltet. Die Dauer der Abschaltung des magnetischen Wechselfeldes ist dabei derart kurz, dass der zu prüfende Schaltkreis auch während der Abschaltung des Wechselfeldes mit Energie versorgt bleibt. Vorzugsweise dauert das Abschalten nur wenige Mikrosekunden, bevorzugt etwa 3 $\mu$s.

Weiterhin erfolgt bevorzugt das Anregen des Schaltkreises mittels des Energiepulses im Rahmen der vorstehend beschriebenen zweiten Variante, d.h. bei kurzzeitig abgeschaltetem Wechselfeld, erst dann, wenn die aus dem vormals vorliegenden, angeschalteten Wechselfeld resultierende sinusförmige Schwingung bereits abgeklungen ist. Nur dann ergibt sich der vorstehend beschriebene Vorteil des einfacheren Auswertens der erfassten Schwingung in vollem Umfang. In diesem Fall entspricht die erfasste Schwingung des Schaltkreises genau der freien, gedämpften Schwingung des Schaltkreises, welche aus der Anregung des Schaltkreises durch den Energiepuls resultiert.

Wie erwähnt, wird im Zusammenhang mit der bevorzugten Ausführungsform des erfindungsgemäßen Verfahrens im Schritt des Auswertens der wie vorstehend beschrieben, erfassten oder ermittelten freien, gedämpften Schwingung des Schaltkreises insbesondere die Eigenresonanzfrequenz des Schaltkreises und die Güte des Schaltkreises in Abhängigkeit von der Feldstärke des vorliegenden magnetischen Wechselfeldes ermittelt. Daraus können, wie beschrieben, in vielfältiger Weise Rückschlüsse auf die Funktionsfähigkeit des Schaltkreises gezogen werden.

Es versteht sich, dass das Verfahren gemäß der bevorzugten Ausführungsform, wie ebenfalls bereits erwähnt, in jeder der beschriebenen Varianten mit jeweils veränderter Feldstärke des magnetischen Wechselfeldes wiederholt werden kann. Auf diese Weise kann insbesondere die Abhängigkeit der Messergebnisse von der Feldstärke überprüft werden. Beispielsweise lassen identische Messergebnisse bei verschiedenen Feldstärken auf einen defekten Schaltkreis schließen.

Gängige Feldstärken, bei denen das Verfahren wiederholt werden kann, sind insbesondere solche, die einer Betriebsfeldstärke eines kontaktlosen kommunizierenden Datenträgers der vorstehend genannten Varianten entspricht, d.h. Feldstärken im Bereich von 0 bis 12 A/m, insbesondere im Bereich von 1,5 bis 7,5 A/m für ISO/ IEC 14443 bzw. 0,15 bis 7,5 A/ m für ISO/ IEC 15693.

Gemäß einer bevorzugten Ausführungsform kann die erfindungsgemäße Messvorrichtung zusätzlich eine Sendeeinrichtung mit einer Sendeantenne umfassen, die eingerichtet ist, ein magnetisches Wechselfeld einer vorgegebenen Frequenz und einer vorgegebenen Feldstärke zu erzeugen. Weiterhin kann die Messvorrichtung eine Kalibriereinrichtung mit einer Kalibrierantenne umfassen. Die Kalibriereinrichtung ist eingerichtet, Parameter des durch die Sendeinrichtung erzeugten magnetischen Wechselfeldes, insbesondere eine Feldstärke des Wechselfeldes in Bereich der Kalibrierantenne, zu erfassen. Alternativ kann eine Kalibrierung der Messvorrichtung auch bereits während der Herstellung der Messvorrichtung erfolgen. In diesem Fall ist die Kalibriereinrichtung während des Prüfens des Schaltkreises verzichtbar.

Vorzugsweise ist die Messvorrichtung gemäß dieser Ausführungsform derart eingerichtet, dass der zu prüfende Schaltkreis, welcher, wie erwähnt, eine Antenne und ein mit der Antenne gekoppeltes elektronisches Bauteil umfasst, in der Messvorrichtung derart angeordnet werden kann, dass die Antenne des Schaltkreises in einem Bereich angeordnet wird, in dem das Wechselfeldes eine vorgegebene Feldstärke aufweist. Dieser Bereich ist, wie erwähnt, vorzugsweise jeweils mittels der Kalibrierantenne in exakter Weise ermittelbar.

Konkret kann dies beispielsweise dadurch erfolgen, dass der zu prüfende Schaltkreis in der Messvorrichtung derart angeordnet wird, dass die Antenne des Schaltkreises und die Kalibrierantenne koaxial zu der Sendeantenne angeordnet sind. Weiter werden die Antenne des Schaltkreises und die Kalibrierantenne auf jeweils verschiedenen Seiten der Sendeantenne angeordnet. Schließlich ist der Abstand, in dem jede der beiden Antennen zu der Sendeantenne angeordnet wird, jeweils der gleiche. Eine vergleichbare Prüfanordnung ist beispielsweise aus der Norm ISO/IEC 10373-6 im Zusammenhang mit der Messung einer feldstärkenabhängigen Lastmodulation bekannt.

Die Sendeeinrichtung der Messvorrichtung ist vorzugsweise eingerichtet, ein magnetisches Wechselfeld unterschiedlicher Feldstärken erzeugen. Wie bereits erwähnt, sollten darunter zumindest Feldstärken im Bereich der Betriebsfeldstärken kontaktlos kommunizierender Geräte liegen, d.h. Feldstärken im Bereich von 0 bis 12 A/m, besonders bevorzugt zwischen 1,5 und 7,5 A/m bzw. zwischen 0,15 und 7,5 A/m.

Die vorliegende Erfindung wird nachfolgend mit Bezug auf die beiliegenden Zeichnungen beispielhaft beschrieben. Darin zeigen:

Figur 1      eine bevorzugte Ausführungsform einer erfindungsgemäßen Messvorrichtung;

Figur 2A     eine bevorzugte Ausführungsform einer erfindungsgemäßen Breitband-Messantenne;

Figur 2B     eine Ersatzschaltung der Breitband-Messantenne aus Figur 2A;

Figur 3      eine bevorzugte Ausführungsform der Messvorrichtung aus Fig.1;

7

Figur 4          Schritte einer bevorzugten Ausführungsform eines erfindungsgemäßen Verfahrens zum Prüfen eines zur kontaktlosen Datenkommunikation eingerichteten Schaltkreises;

Figur 5          Schritte einer ersten Variante einer bevorzugten Ausführungsform des Verfahrens aus Fig. 4;

Figur 6          den Verlauf einer freien, gedämpften Schwingung;

Figur 7          exemplarisch den Verlauf einer Schwingung, wie sie in Schritt S4 aus Figur 5 erfasst werden kann;

Figur 8          exemplarisch Teilschritte des Auswertens der erfassten Schwingung aus Figur 7;

Figuren 9A und 9B    exemplarisch das Ermitteln einer Betriebsresonanzfrequenz eines zu prüfenden Schaltkreises;

Figur 10A          ein erfasstes Signal gemäß einer zweiten Variante des Verfahrens nach Figur 4; und

Figur 10B          die Schritte eines Verfahrens gemäß dieser zweiten Variante.

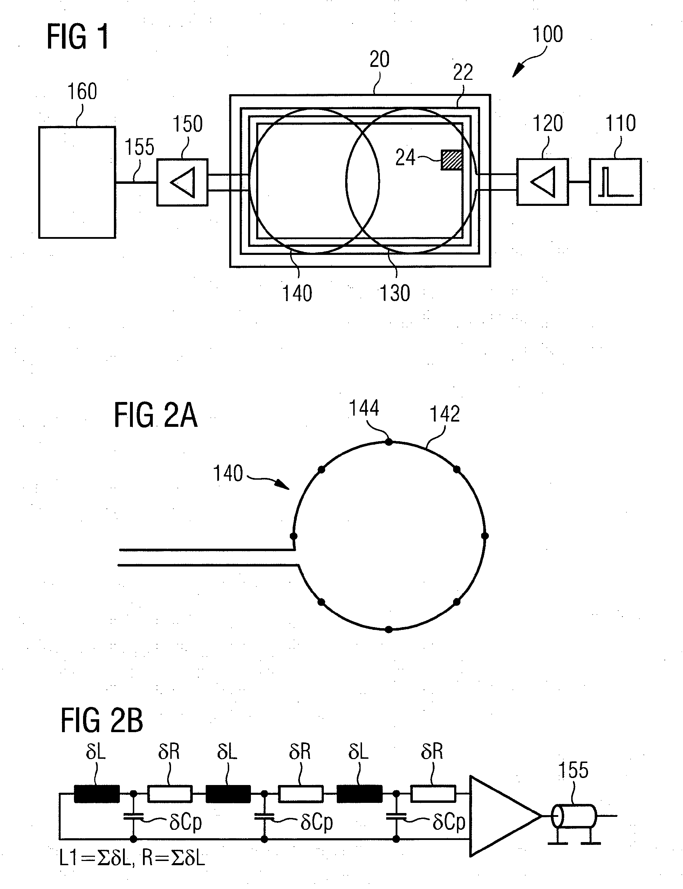

Die in Figur 1 exemplarisch dargestellte Messevorrichtung 100 dient zum Prüfen eines zur kontaktlosen Datenkommunikation eingerichteten Schaltkreises 20 in Form eines RFID- oder NFC-Moduls eines Endgeräts. Dieser Schaltkreis umfasst eine Antennenspule 22, welche mit einem elektronischen Bauteils 24 zu einem zu prüfenden Schaltkreis 20 verbunden ist.

Die Messvorrichtung 100 umfasst einen Impulsgeber 110, der vorzugsweise über einen Verstärker 120 mit einer Erregerspule 130 verbunden ist. Mittels eines durch den Impulsgeber 110 erzeugten Energiepulses, vorzugsweise in Form eines Dirac-Stoßes, kann der zu prüfende Schaltkreis 20 über die Erregerspule kontaktlosen angeregt werden.

Eine Messantenne 140 der Messvorrichtung 100 ist eingerichtet, eine Schwingung des zu prüfenden Schaltkreises 20 zu erfassen und vorzugsweise über einen Verstärker 150 an eine Auswertungseinrichtung 160 weiterzuleiten. Die Auswertungseinrichtung 160 kann beispielsweise als Oszilloskop vorliegen.

Erregerspule 130 und Messantenne 140 werden in geeignetem, vorzugsweise geringem Abstand neben der Antenne 22 des zu prüfenden Schaltkreises 20 angeordnet

Wie im Fig.1 durch die teilweise überlappende Anordnung angedeutet, sind die Messantenne 140 und Erregerspule 130 dabei orthogonal zueinander angeordnet. Dies hat, wie vorstehend beschrieben, die Auswirkungen, dass in die Messantenne 140 möglichst kein Signal der Erregerspule 130 eingekoppelt wird. Die Erregerspule 130 und die Messantenne 140 können auf einem geeigneten, flächigen Träger angeordnet werden.

Um eine günstige Signalauskopplung zu erreichen, sollte das mittels der Messantenne 140 erfasste Signal möglichst hochohmig ausgekoppelt werden. Daher wird unmittelbar an die Messantenne 140, wie in Figur 1 dargestellt, ein Verstärker 150 mit hochohmigem Eingang angeordnet. Vorzugsweise wird als Verstärker 150 ein Impedanzwandler eingesetzt. Dieser besitzt vorzugsweise eine Ausgangsimpedanz von 50$\Omega$ und ist mittels eines Koaxialkabels 155 mit der Auswertungseinrichtung 160 verbunden, beispielsweise einem Oszilloskop. Dieses sollte dabei vorzugsweise eine Eingangsimpedanz von 50 $\Omega$ aufweisen. Damit können Reflexionen wirkungsvoll vermieden werden.

Figur 2A zeigt eine erfindungsgemäße Breitband-Messantenne 140, die eingerichtet sein kann, als Messantenne 140 der Messvorrichtung 100 aus Fig.1 zu dienen. Die Breitband-Messantenne 140 umfasst eine Leiterschleife und eine Mehrzahl ohmscher Widerstände 144, wobei die Widerstände 144 in vorgegebenen Abständen entlang der Leiterschleife in die Leiterschleife eingefügt sind. Sich dabei entlang der Leiterschleife ergebende, benachbarte Leitungssegmente 142 sind durch je einen der ohmschen Widerstände 144 verbunden, wodurch Leitungssegmente 142 und Widerstände 144 dabei jeweils abwechselnd und in Reihe geschaltet sind.

Die Abstände zwischen benachbarten Widerständen 144 entlang der Leiterschleife sind vorzugsweise jeweils gleich. Die Anzahl der Widerstände 144 bzw. der Leitungssegmente 142 ist variabel. In der Regel sind sämtliche der Widerstände 144 gleich dimensioniert. Als Widerstände 144 können beispielsweise direkt auf die Leiterbahnen lötbare SMD-Widerstände verwendet werden.

Figur 2B zeigt ein Ersatzschaltbild der Breitband-Messantenne 140 aus Figur 2A. Darin entsprechen die symbolisch gezeigten Widerstände $\delta R$ den ohmschen Widerständen 144, die Elemente $\delta L$ addieren sich zu der Induktivität L1 der Leiterschleife und die sich entlang der Leiterschleife bildenden parasitären Kapazitäten sind mit $\delta Cp$ bezeichnet. Dadurch, dass die Widerstände 144 im Wesentlichen gleichmäßig entlang der Leiterschleife verteilt angeordnet sind, werden die parasitären Kapazitäten $\delta Cp$ nicht als Gesamtkapazität Cp wirksam, wodurch die Breitband-Messantenne 140 wirkungsvoll "bedämpft" werden kann.

Ein weiterer Vorteil der Breitband-Messantenne 140 aus Figur 2A besteht darin, dass bedingt durch den hohen Widerstand der Leiterschleife eine während eines Messvorgangs in der Breitband-Messantenne 140 fließender Strom gegen Null geht. Mit anderen Worten, an den Anschlüssen der Breitband-Messantenne 140 wird praktisch nur die induzierte Spannung gemessen. Wird der Strom in der Breitband-Messantenne 140 sehr klein, so wird dadurch auch eine Rückwirkung auf einen Messgegenstand, beispielsweise die Antenne 22 des zu prüfenden Schaltkreises 20, minimiert. Dadurch wird ein Messergebnis durch die Breitband-Messantenne 140 praktisch nicht beeinflusst, beispielsweise falls die Breitband-Messantenne 140 als Messantenne der Messvorrichtung 100 verwendet wird.

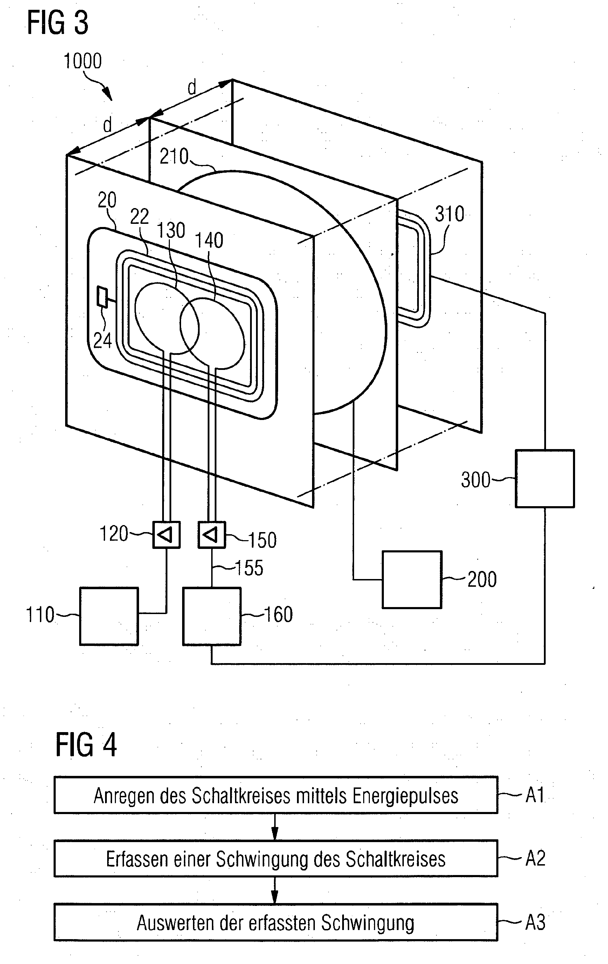

Gemäß einer bevorzugten Ausführungsform, die in Fig. 3 gezeigt ist, kann die Messvorrichtung 100 aus Fig.1 zusätzlich eine Sendeeinrichtung 200 und eine Kalibriereinrichtung 300 umfassen. Eine entsprechend erweiterte Messvorrichtung wird mit dem Bezugszeichen 1000 bezeichnet.

Mittels der Sendeeinrichtung 200 und der Sendeantenne 210 kann ein magnetisches Wechselfeld einer einstellbaren Feldstärke H und mit einer vorgegebenen Frequenz erzeugt werden. Insbesondere ist die Sendeeinrichtung 200 eingerichtet, ein magnetisches Wechselfeld mit einer für den Betrieb eines zu prüfenden Schaltkreises 20 üblichen Betriebsfeldstärke H zu erzeugen, beispielsweise 1,5 bis 7,5 A/m. Bevorzugt umfasst der Bereich, den die Sendeeinrichtung 200 abdeckt, ein größeres Intervall, beispielsweise 0 bis 12 A/ m, bevorzugt auch noch höhere Feldstärken.

Die Antenne 22 des Schaltkreises 20, wenn der Schaltkreis 20 zur Prüfung in der Messvorrichtung 1000 angeordnet ist, ist zu der Sendeantenne 210 koaxial angeordnet.

Ebenfalls koaxial zu der Sendeantenne 210 ist eine Kalibrierantenne 310 der Kalibriereinrichtung 300 angeordnet. Die Kalibriereinrichtung 300 mit der Kalibrierantenne 310 kann, wie erwähnt, Teil der Messvorrichtung 1000 sein. Die Kalibrierantenne 310 sowie die Antenne 22 des zu prüfenden Schaltkreises 20 sind, wie illustriert, zu jeweils verschiedenen Seiten der Sendeantenne 210 und in jeweils gleichem Abstand d zu der Sendeantenne 210 angeordnet.

Die Kalibriereinrichtung 300 mit der Kalibrierantenne 310 dient dazu, die Feldstärke H des mittels der Sendeeinrichtung 200 erzeugten Wechselfeldes in einem definierten Abstand d von der Sendeantenne 210 genau zu erfassen. Aufgrund der Tatsache, dass die Antenne 22 eines zu prüfenden Datenträgers 20 in der Messvorrichtung 1000 relativ zu der Sendeantenne 210 in gleicher räumlicher Anordnung, koaxial, und gleichem Abstand d wie die Kalibrierantenne 310 angeordnet werden kann, kann davon ausgegangen werden, dass im Bereich der Antenne 22 des zu prüfenden Schaltkreises 20 genau die gleiche Feldstärke H vorliegt, wie im Bereich der Kalibrierantenne 310.

Die Erregerspule 130 und die Messantenne 140 können auf der der Sendeantenne 210 zugewandten oder, wie in Fig. 3 illustriert, auf der der Sendeantenne 210 abgewandten Seite des Schaltkreises 20 angeordnet sein.

In Figur 4 sind wesentliche Schritte einer bevorzugten Ausführungsform eines Verfahrens zum Prüfen eines zur kontaktlosen Datenkommunikation eingerichteten Schaltkreises 20 angegeben.

In Schritt A1 wird der Schaltkreis 20 mittels eines Energiepulses angeregt. Dies kann mittels der Erregerspule 130 aus Figur 1 durch Zusammenwirken mit dem Impulsgeber 110 erfolgen. Das Anregen erfolgt vorzugsweise mittels eines gepulsten Magnetfeldes induktiv, wobei das Magnetfeld vorzugsweise durch einen einzelnen Strompuls in Form eines Dirac-Stoßes erzeugt wird.

In Schritt A2 wird eine Schwingung des Schaltkreises 20 in Antwort auf das Anregen des Schaltkreises 20 erfasst. Dazu dient die Messantenne 140 aus Figur 1 bzw. Fig. 2A. Die erfasste Schwingung entspricht dabei einer freien, gedämpften Schwingung des Schaltkreises 20.

In Schritt A3 wird die erfasste Schwingung durch eine Auswertungseinrichtung, beispielsweise die Auswertungseinrichtung 160 aus Fig.1, ausgewertet. Wie vorstehend beschrieben, kann in dieser Weise die Funktionsfähigkeit des Schaltkreises geprüft und insbesondere eine Eigenresonanzfrequenz und/ oder eine Güte des Schaltkreises 20 ermittelt werden.

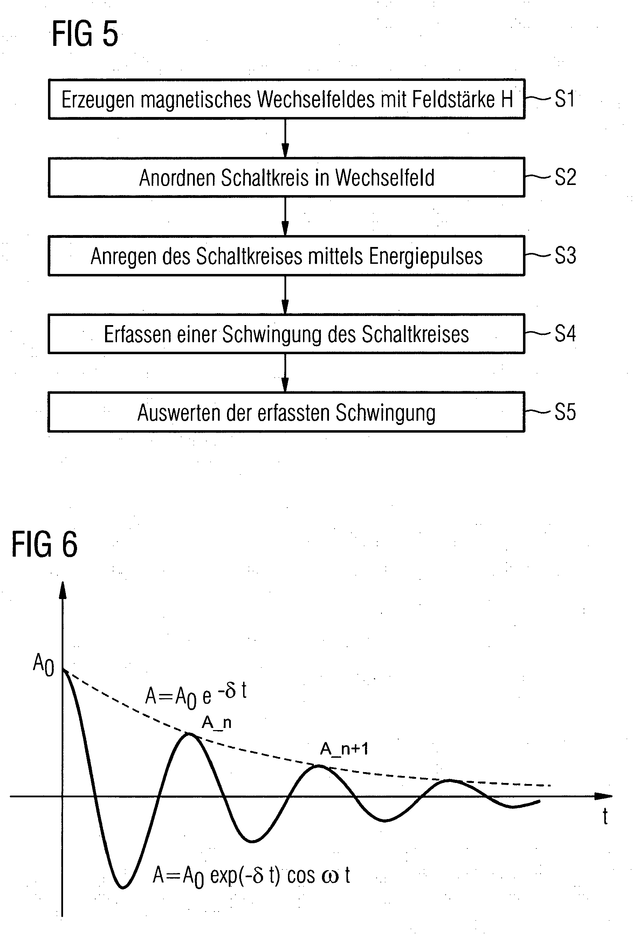

Mit Bezug auf Figur 5 wird eine erste Variante einer bevorzugten Ausführungsform des vorstehend mit Bezug auf Fig. 4 beschriebenen Verfahrens erläutert. Darin entsprechen die Schritte S3 bis S5 den Schritte A1 bis A3 aus Fig. 4. Die bevorzugte Ausführungsform umfasst zusätzlich, dem Schritt S3 vorgeschaltet, die Schritte S1 und S2.

In Schritt S1 wird ein magnetisches Wechselfeld mit einer vorgegebenen, definierten Feldstärke H erzeugt. Dies kann mittels der mit Bezug auf Figur 3 erläuterten Sendeeinrichtung 200 erfolgen.

Im Schritt S2 wird der Schaltkreis 20 in dem erzeugten magnetischen Wechselfeld angeordnet. Die Anordnung erfolgt derart, dass die Feldstärke H im Bereich der Antenne 22 des zu prüfenden Schaltkreises 20 genau einstellbar ist, wie dies ebenfalls mit Bezug auf Figur 3 beschrieben worden ist.

Das Anordnen des Schaltkreises 20 im Wechselfeld gemäß Schritt S2 versetzt den Schaltkreis 20 aufgrund der Sendefrequenz der Sendeantenne 210 in eine bezüglich Amplitude und Frequenz konstante sinusförmige Schwingung.

Das Anregen des Schaltkreises 20 mittels des Energiepulses gemäß Schritt S3 resultiert in einer freien, gedämpften Schwingung des Schaltkreises 20, wie sie exemplarisch in Figur 6 dargestellt ist.

Es sei an dieser Stelle angemerkt, dass im Zusammenhang mit der vorliegenden Erfindung der Begriff des "Anregens" des Schaltkreises ausschließlich im Zusammenhang mit dem Anregen des Schaltkreises mittels des Energiepulses (Schritte A1, S3) verwendet werden soll. Der Einfluss des magnetischen Wechselfeldes, welcher ebenfalls eine Wirkung auf das Schwingungsverhalten des Schaltkreises 20 hat, wird vorliegend nicht als "Anregen" des Schaltkreises im Sinne der Erfindung verstanden.

Figur 6 zeigt den theoretischen Verlauf einer freien, gedämpften Schwingung A(t) im Verlauf der Zeit t. Die Funktion A(t) kann dabei dem Strom I oder der Spannung U entsprechen. Die Kreisfrequenz ω entspricht der Eigenresonanzfrequenz des entsprechenden Schaltkreises 20 multipliziert mit 2 n. Aus dem Abklingkoeffizienten δ kann die Güte des Schaltkreises 20 bestimmt werden.

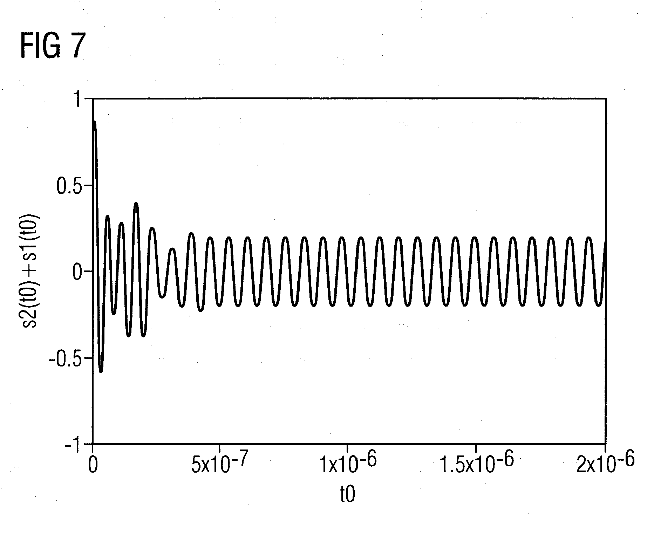

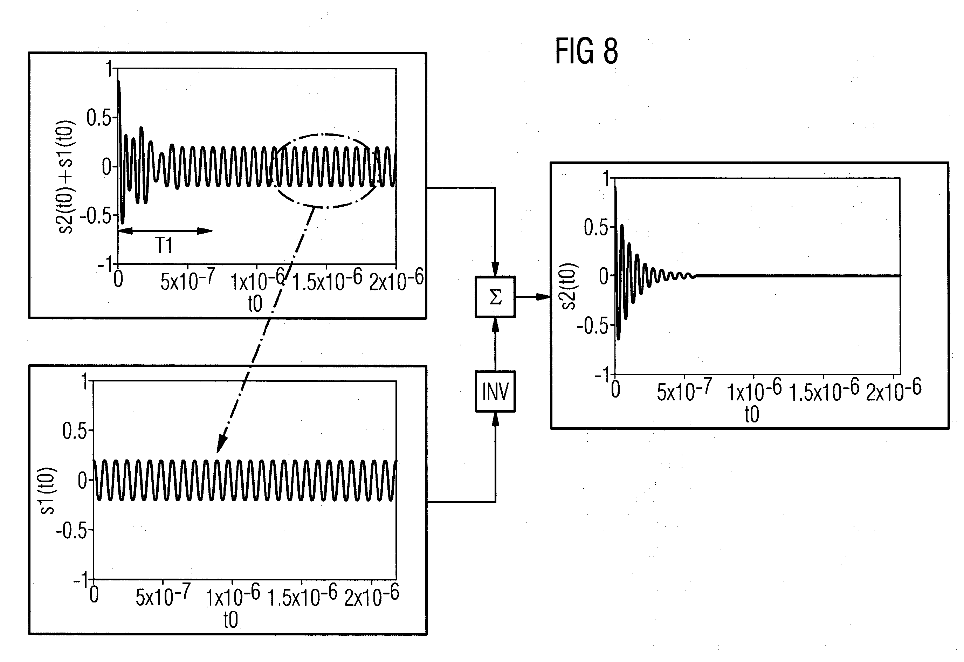

Figur 7 zeigt eine Überlagerung der erwähnten, konstanten sinusförmigen Schwingung mit einer freien, gedämpften Schwingung des Schaltkreises 20. Ein solches Signal kann von der Messantenne 140 im Schritt S4 erfasst werden. Um aus einer Schwingung, wie sie in Figur 7 dargestellt ist, eine Resonanzfrequenz des zu prüfenden Schaltkreises 20 zu ermitteln, muss derjenige Anteil der Schwingung, der der konstanten sinusförmigen Schwingung entspricht, welche durch das magnetische Wechselfeld erzeugt wird, von der erfassten Schwingung subtrahiert werden. Eine mögliche Vorgehensweise, eine solche Auswertung durchzuführen, ist in Figur 8 illustriert.

Der Verlauf der freien, gedämpften Schwingung kann beispielsweise mittels der Kalibrierantenne 310 erfasst und von der Auswertungseinrichtung 160 analysiert und gespeichert werden. Dazu ist die Kalibriereinrichtung 300 mit der Auswertungseinrichtung 160 verbunden. Der Schritt des Analysierens kann vor dem Anregen des Schaltkreises 20 mittels des Energiepulses erfolgen, oder, wie in Figur 8 illustriert, in ausreichendem zeitlichen Abstand nach dem Anregen des Schaltkreises 20 durch den Energiepuls, nämlich dann, wenn die freie, gedämpfte Schwingung bereits abgeklungen ist. Eine entsprechende Zeitspanne ist in Figur 8 mit T1 bezeichnet. Um die sinusförmige Schwingung von dem erfassten Gesamtsignal zu subtrahieren, wird diese invertiert und zu der erfassten Schwingung addiert, wie dies in Figur 8 exemplarisch dargestellt ist. In der rechten Teilfigur ist das Ergebnis, nämlich die freie, gedämpfte Schwingung des Schaltkreises 20, wie sie aus der Anregung des Schaltkreises 20 durch den Energiepuls resultiert, dargestellt.

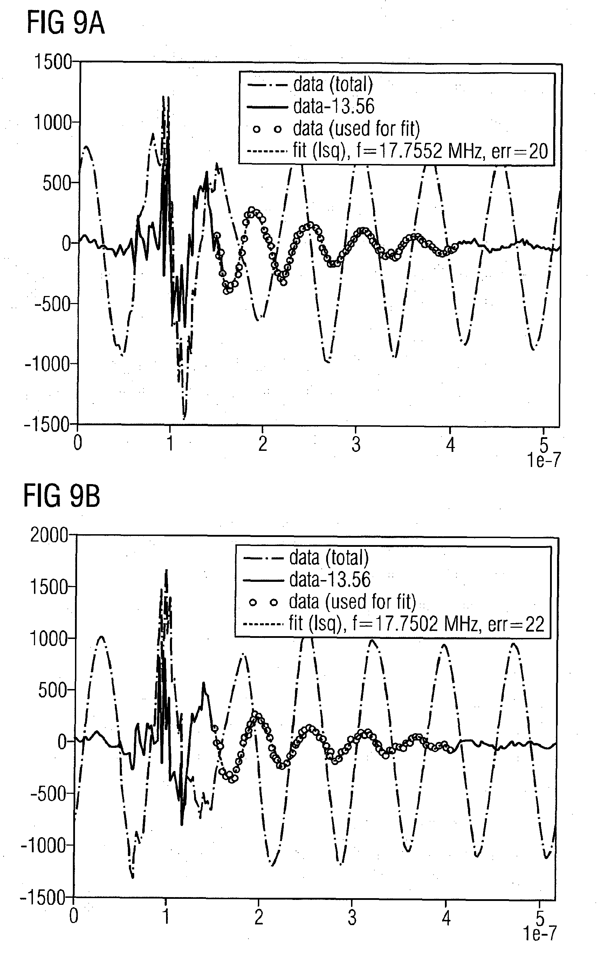

Ein Beispiel für eine Messung einer Betriebsresonanzfrequenz eines zu prüfenden Schaltkreises mittels des Verfahrens gemäß Fig. 5 ist in Figur 9A dargestellt. Hierbei ist das erfasste Gesamtsignal, d.h. die sinusförmige Schwingung überlagert mit der freien, gedämpften Schwingung, strich-punktiert dargestellt. Nach dem Erfassen dieses Signals wurde der sinusförmige Anteil, der dem konstanten Wechselfeldes entspricht, subtrahiert. Das daraus resultierende Signal ist mit einer durchgezogenen Linie dargestellt und zeigt in anschaulicher Weise das Abklingen der freien, gedämpften Schwingung nach einem Dirac-Stoß. Schließlich zeigt Figur 9A noch das Ergebnis nach Anwendung eines Fit-Algorithmus, mit einer gestrichelten Linie, wobei verwendete Datenpunkte sichtbar gemacht sind.

Eine zweite Messung der Resonanzfrequenz desselben Schaltkreises 20, jedoch bei unterschiedlicher zweiter konstanter Feldstärke H', ist in Figur 9B dargestellt. Es zeigt sich, dass die Resonanzfrequenz des Schaltkreises 20 gegenüber der ersten Messung, mit der ersten Feldstärke H, sich um ca. 200 kHz unterscheidet. Dies ist auf die Feldstärkenabhängigkeit der Resonanzfrequenz des Schaltkreises 20 zurückzuführen.

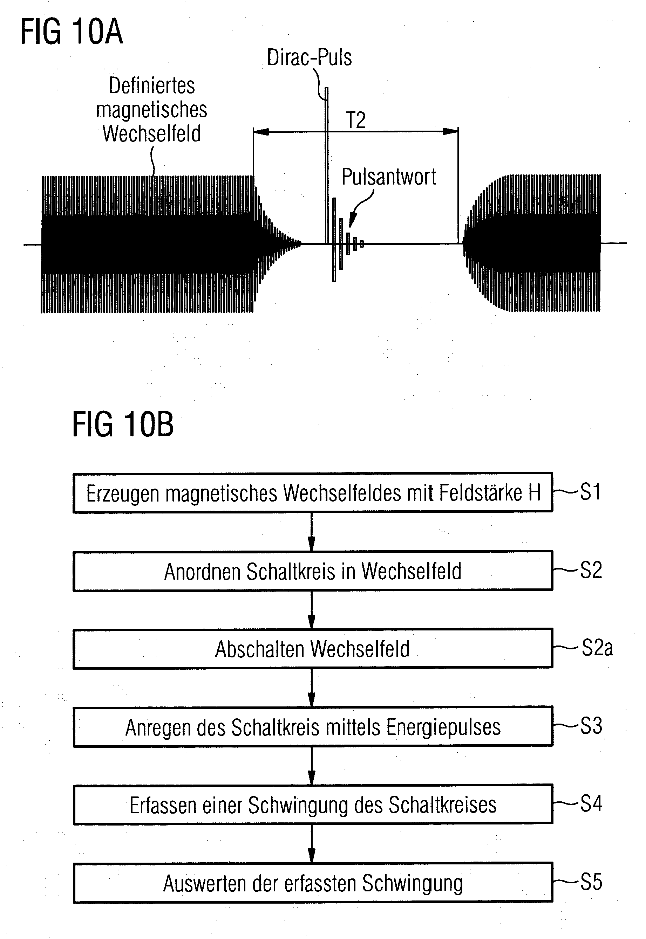

Mit Bezug auf Figur 10A ist der Signalverlauf eines von der Messantenne 140 erfassten Signals gemäß eines alternativen Prüfverfahrens gemäß einer zweiten Variante der vorstehend beschriebenen, bevorzugten Ausführungsform dargestellt. Wie mit Bezug auf Fig.10B illustriert, gleichen sich die hier vorgestellte zweite Variante und die vorstehend mit Bezug auf die Figuren 5 und 7 bis 9 beschriebene erste Variante in den Schritten S1 bis S5.

Die hier zugrunde liegende zweite Variante weicht von der vorstehend beschriebenen ersten Variante dahingehend ab, dass das magnetische Wechselfeld zumindest kurzzeitig abgeschaltet wird (vgl. Schritt S2a in Fig.10B).

Während im Rahmen der mit Bezug auf die Figuren 5 und 7 bis 9 beschriebenen Variante das Anregen des Schaltkreises 20 (Schritt S3 in Figur 5) erfolgte, während das magnetische Wechselfeld angeschaltet war, d.h. mit konstanter Feldstärke H vorlag, erfolgt das Anregen gemäß der mit Bezug auf die Figuren 10A und 10B dargestellten Variante bei abgeschaltetem magnetischen Feld.

Wie in Figur 10A illustriert, wird das magnetische Wechselfeld vorzugsweise nur kurzzeitig abgeschaltet, beispielsweise für eine Zeitdauer T2, welche zum Beispiel ca. 3 µs betragen kann. In dieser Pause erfolgt das Anregen des Schaltkreises 20 mittels des Energiepulses, beispielsweise eines Direkt-Pulses. Dadurch, dass der Puls sehr kurz nach dem Ausschalten des magnetischen Wechselfeldes erfolgt, ist der Schaltkreis 20 weiterhin ausreichend mit Energie versorgt, so dass Schaltungs- und Betriebszustände verschiedener Elemente des Schaltkreises 20 im Wesentlichen den gleichen Zustand aufweisen, wie bei konstant vorliegendem Wechselfeld. Das Messergebnis, d.h. die ermittelte Resonanzfrequenz des Schaltkreises 20, wird sich im Vergleich zu einer Messung mit dauerhaft angeschaltetem Wechselfeld daher praktisch nicht oder allenfalls unwesentlich unterscheiden.

Für die Wirkungsweise der zweiten Variante aus Fig.10B ist es nicht wesentlich, wann und ob das magnetische Wechselfeld wieder angeschaltet wird. Grundsätzlich kann ein erneutes Anschalten unterbleiben. In der Regel aber wird die Abschaltung nur sehr kurzfristig sein, wie vorstehend beschrieben. Dies erlaubt beispielsweise auf einfache Weise eine mehrfache Wiederholung der Prüfung.

Vorzugsweise erfolgt das Anregen des Schaltkreises 20 innerhalb der Zeitspanne, in der das Wechselfeld abgeschaltet ist, erst dann, wenn die sinusförmige Schwingung, welche durch das Wechselfeld hervorgerufen worden ist, abgeklungen ist, wie dies in Figur 10A dargestellt ist.

Diese zweite Variante des Prüfverfahrens hat den Vorteil, dass das Auswerten der erfassten Schwingung in Antwort auf das Anregen des Schaltkreises 20 durch den Energiepuls vereinfacht wird. Wie in Figur 10A dargestellt, entspricht die in Schritt S4 aus Figur 10B erfasste Schwingung gemäß der vorliegenden zweiten Variante bereits nur die freie, gedämpfte Schwingung des Schaltkreises 20. Demzufolge kann auf eine Subtraktion weiterer, erfasster Schwingungsanteile verzichtet werden.

**Patentansprüche**

1. Verfahren zum Prüfen eines zur kontaktlosen Datenkommunikation eingerichteten Schaltkreises (20) eines Endgeräts, wobei der Schaltkreis (20) eine induktiv koppelnde Antenne (22) und ein mit der Antenne (22) gekoppeltes elektronisches Bauteil (24) umfasst, umfassend die Schritte:

   - Anregen (A1; S3) des Schaltkreises (20) mittels eines Energiepulses;
   - Erfassen (A2; S4) einer Schwingung des Schaltkreises (20) in Antwort auf die Anregung durch den Energiepuls;
   - Auswerten (A3; S5) der erfassten Schwingung des Schaltkreises (20), insbesondere hinsichtlich einer Eigenresonanzfrequenz des Schaltkreises (20).

2. Verfahren nach Anspruch 1, **dadurch gekennzeichnet, dass** das Anregen des Schaltkreises (20) als induktives Anregen mittels eines gepulsten Magnetfeldes erfolgt, wobei das Magnetfeld vorzugsweise durch einen einzelnen Strompuls erzeugt wird und/ oder wobei der Strompuls vorzugsweise als Gleichstrompuls in Form eines Dirac-Stoßes erzeugt wird.

3. Verfahren nach einem der Ansprüche 1 oder 2, **dadurch gekennzeichnet, dass** das Anregen des Schaltkreises (20) kontaktlos mittels einer externen Erregerspule (130) durchgeführt wird und/ oder dass das Erfassen der Schwingung des Schaltkreises (20) kontaktlos mittels einer externen Messantenne (140) durchgeführt wird.

4. Verfahren nach einem der Ansprüche 1 bis 3, **gekennzeichnet durch** die weiteren Schritte vor dem Anregen des Schaltkreises (20) **durch** den Energiepuls:

   - Erzeugen (S1) eines magnetischen Wechselfeldes vorgegebener Feldstärke;
   - Anordnen (S2) des Schaltkreises in dem Wechselfeld.

5. Verfahren nach Anspruch 4, **dadurch gekennzeichnet, dass** das Wechselfeld mittels einer Sendeantenne (210) erzeugt wird und dass die Feldstärke (H) des Wechselfeldes mittels einer Kalibrierantenne (310) gemessen wird, um ein Erzeugen des Wechselfeldes gemäß der vorgegebenen Feldstärke (H) zu ermöglichen, wobei die Kalibrierantenne (310) und die Antenne (22) des Schaltkreises (20) vorzugsweise derart relativ zu der Sendeantenne (210) angeordnet werden, dass im Bereich der Kalibrierantenne (310) und im Bereich der Antenne (22) des Schaltkreises jeweils ein magnetisches Wechselfeld der gleichen Feldstärke (H) vorliegt.

6. Verfahren nach einem der Ansprüche 4 oder 5, **dadurch gekennzeichnet, dass** das Anregen des Schaltkreises (20) durch den Energiepuls bei konstant vorliegendem magnetischem Wechselfeld erfolgt.

7. Verfahren nach Anspruch 6, **dadurch gekennzeichnet, dass** das Erfassen der Schwingung des Schaltkreises (20) ein Erfassen einer Überlagerung einer durch das Wechselfeld hervorgerufenen sinusförmigen Schwingung des Schaltkreises (20) mit einer freien, gedämpften Schwingung des Schaltkreises (20) umfasst, wobei die freie, gedämpfte Schwingung aus der Anregung durch den Energiepuls resultiert.

8. Verfahren nach einem der Ansprüche 4 oder 5, **dadurch gekennzeichnet, dass** das magnetische Wechselfeld abgeschaltet wird (S2a) und dass das Anregen des Schaltkreises (20) durch den Energiepuls bei abgeschaltetem magnetischem Wechselfeld erfolgt.

9. Verfahren nach Anspruch 8, **dadurch gekennzeichnet, dass** das Wechselfeld nur kurzzeitig abgeschaltet wird und die Dauer der Abschaltung des magnetischen Wechselfeldes derart kurz ist, dass der Schaltkreis (20) auch während der Abschaltung des Wechselfeldes mit Energie versorgt bleibt, vorzugsweise wenige Mikrosekunden, besonders bevorzugt etwa 3 µs, wobei die Anregung mittels des Energiepulses bei abgeschaltetem magnetischem Wechselfeld vorzugsweise erst dann erfolgt, wenn die aus dem Wechselfeld resultierende sinusförmige Schwingung abgeklungen ist.

10. Messvorrichtung (100) zum Prüfen eines zur kontaktlosen Datenkommunikation eingerichteten Schaltkreises (20) eines Endgeräts, wobei der Schaltkreis (20) eine induktiv koppelnde Antenne (22) und ein mit der Antenne (22) gekoppeltes elektronisches Bauteil (24) umfasst, wobei die Messvorrichtung (100) umfasst:

- einen Impulsgeber (110), der eingerichtet ist, einen in der Messvorrichtung (100) anordenbaren, zu prüfenden Schaltkreis (20) über eine an den Impulsgeber (110) angeschlossene Erregerspule (130) kontaktlos anzuregen;
- eine Messantenne (140), die eingerichtet ist, eine Schwingung des Schaltkreises (20) zu erfassen; und
- eine Auswertungsvorrichtung (160), welche mit der Messantenne (140) verbunden ist und eingerichtet ist, die von der Messantenne (140) erfasste Schwingung des Schaltkreises (20) auszuwerten, insbesondere hinsichtlich einer Eigenresonanzfrequenz des Schaltkreises (20).

11. Messvorrichtung (1000) nach Anspruch 10, **gekennzeichnet durch**

- eine Sendeeinrichtung (200) mit einer Sendeantenne (210), wobei die Sendeeinrichtung (200) eingerichtet ist, ein magnetisches Wechselfeld einer vorgegebenen Frequenz und einer vorgegebenen Feldstärke (H) zu erzeugen; und vorzugsweise
- eine Kalibriereinrichtung (300) mit einer Kalibrierantenne (310), wobei die Kalibriereinrichtung (300) eingerichtet ist, Parameter des **durch** die Sendeeinrichtung (200) erzeugten Wechselfeldes, insbesondere eine Feldstärke (H) im Bereich der Kalibrieantenne (310), zu erfassen.

12. Breitband-Messantenne (140), umfassend eine Leiterschleife und eine Mehrzahl ohmscher Widerstände (144), wobei die Widerstände (144) in vorgegebenen Abständen entlang der Leiterschleife in die Leiterschleife eingefügt sind, wobei die Abstände zwischen je zwei entlang der Leiterschleife benachbarten Widerständen (144) vorzugsweise gleich sind.

13. Breitband-Messantenne (140) nach Anspruch 12, **dadurch gekennzeichnet, dass** durch das Einfügen der Widerstände (144) in die Leiterschleife eine Mehrzahl von Leitungssegmenten (142) der Leiterschleife gebildet sind, wobei entlang der Leiterschleife benachbarte Leitungssegmente (142) durch je einen der ohmschen Widerstände (144) verbunden werden, wodurch Leitungssegmente (142) und Widerstände (144) dabei jeweils abwechselnd und in Reihe geschaltet sind.

14. Breitband-Messantenne (140) nach Anspruch 12 oder 13, **dadurch gekennzeichnet, dass** die Breitband-Messantenne (140) eingerichtet ist, als Messantenne (140) einer Messvorrichtung (100; 1000) nach einem der Ansprüche 10 oder 11 zu dienen.

15. Messvorrichtung (1000) nach einem der Ansprüche 10 oder 11, **dadurch gekennzeichnet, dass** die Messantenne (140) als Breitband-Messantenne (140) gemäß Anspruch 14 ausgebildet ist.

## FIG 1

160

155

150

20   22   100

24

140   130

120   110

## FIG 2A

144   142

140

## FIG 2B

$\delta L$   $\delta R$   $\delta L$   $\delta R$   $\delta L$   $\delta R$

$\delta Cp$   $\delta Cp$   $\delta Cp$

155

$L1 = \Sigma \delta L, \ R = \Sigma \delta L$

## FIG 3

## FIG 4

| | |
|---|---|
| Anregen des Schaltkreises mittels Energiepulses | ~A1 |
| ↓ | |
| Erfassen einer Schwingung des Schaltkreises | ~A2 |
| ↓ | |
| Auswerten der erfassten Schwingung | ~A3 |

## FIG 5

| | |
|---|---|
| Erzeugen magnetisches Wechselfeldes mit Feldstärke H | ~S1 |
| Anordnen Schaltkreis in Wechselfeld | ~S2 |
| Anregen des Schaltkreises mittels Energiepulses | ~S3 |
| Erfassen einer Schwingung des Schaltkreises | ~S4 |
| Auswerten der erfassten Schwingung | ~S5 |

## FIG 6

$A_0$

$A = A_0 \, e^{-\delta t}$

$A\_n$

$A\_n+1$

$t$

$A = A_0 \exp(-\delta t) \cos \omega t$

FIG 7

FIG 8

## FIG 9A

Legend:
- —·—· data (total)
- ——— data-13.56
- o  o data (used for fit)
- ------- fit (lsq), f=17.7552 MHz, err=20

## FIG 9B

Legend:
- —·— data (total)
- ——— data-13.56
- o  o data (used for fit)
- ------- fit (lsq), f=17.7502 MHz, err=22

# FIG 10A

Dirac-Puls

Definiertes
magnetisches
Wechselfeld

T2

Pulsantwort

# FIG 10B

| Erzeugen magnetisches Wechselfeldes mit Feldstärke H | S1 |

| Anordnen Schaltkreis in Wechselfeld | S2 |

| Abschalten Wechselfeld | S2a |

| Anregen des Schaltkreis mittels Energiepulses | S3 |

| Erfassen einer Schwingung des Schaltkreises | S4 |

| Auswerten der erfassten Schwingung | S5 |

**IN DER BESCHREIBUNG AUFGEFÜHRTE DOKUMENTE**

**In der Beschreibung aufgeführte Nicht-Patentliteratur**

- **KLAUS FINKENZELLER.** RFID-Handbuch. Carl Hanser Verlag, 2012